# EUROPÄISCHE PATENTSCHRIFT

(11) **EP 2 796 804 B1**
(45) Veröffentlichungstag und Bekanntmachung des Hinweises auf die Patenterteilung: **15.07.2015**
(21) Anmeldenummer: 13002232.0
(22) Anmeldetag: 26.04.2013
(51) Int. Cl.: H05K 5/06, F24H 3/04, F24H 9/02, F24H 9/14

(54) **Versiegeltes Gehäuse und Verfahren zu dessen Herstellung**
Sealed housing and method of forming the same
Boîtier scellé et procédé destiné à sa fabrication

(43) Veröffentlichungstag der Anmeldung: 29.10.2014
(73) Patentinhaber: Eberspächer catem GmbH & Co. KG, 76863 Herxheim (DE)
(72) Erfinder: Bohlender, Franz, 76870 Kandel (DE); Niederer, Michael, 76889 Kapellen-Drusweiler (DE)
(74) Vertreter: Grünecker Patent- und Rechtsanwälte PartG mbB

(56) Entgegenhaltungen:
- DE-A1- 19 642 442
- FR-A1- 2 411 772
- FR-A1- 2 471 324

## Beschreibung

Die vorliegende Erfindung betrifft ein versiegeltes Gehäuse einer in ein Kraftfahrzeug einzubauenden Vorrichtung sowie ein Verfahren zu deren Herstellung.

Versiegelte Gehäuse in Kraftfahrzeugen können beispielsweise Steuervorrichtungen aufnehmen, die staubdicht und hermetisch in dem Gehäuse abgeschlossen sein sollen. Dabei handelt es sich insbesondere um elektronische Steuervorrichtungen, die anfällig gegen Verschmutzungen und Umwelteinflüsse sowie feuchte Luft sein können. Ein versiegeltes Gehäuse der vorliegenden Erfindung kann aber auch ein Gehäuse sein, in dem ein Medium geführt bzw. aufgenommen ist.

Ein solches versiegeltes Gehäuse ist beispielsweise aus der DE 196 42 442 A1 bekannt. Diese Druckschrift offenbart ein versiegeltes Gehäuse einer elektrischen Heizvorrichtung mit einem Gehäuseunterteil und einem Gehäusedeckel, der unter Zwischenlage eines Dichtelementes an dem Gehäuseunterteil anliegt.

Diese Druckschrift offenbart den Oberbegriff der Ansprüche 1,7 und 15.

Ein weiterer gattungsbildender Stand der Technik ist mit der auf die vorliegende Anmelderin zurückgehenden EP 2 440 004 A1 gegeben. Diese Druckschrift offenbart in ihrer Figur 7 zwei identisch ausgebildete Gehäuseteile, die unter Zwischenlage einer Dichtlage miteinander verbunden sind und jeweils eine Zirkulationskammer für ein zu erwärmendes Fluid ausbilden.

Dieser vorbekannte Stand der Technik wie auch bei dem Stand der Technik nach DE 196 42 442 A1 offenbart im Kern einen Wasserheizer, d.h. einen Heizer, in dessen Gehäuseunterteil ein flüssiges Medium aufgenommen ist. Das Gehäuseunterteil ist über den Gehäusedeckel abgeschlossen, wobei das Dichtelement eine Leckage an der Fügestelle zwischen dem Gehäuseunterteil und dem Gehäusedeckel verhindert.

Bei den zuvor erwähnten Beispielen aus dem Stand der Technik zu versiegelten Gehäusen ist der Gehäusedeckel mit dem Gehäuseunterteil verschraubt. In der Kfz-Industrie müssen heutzutage aus Gründen der Qualitätskontrolle Schraubverbindungen besonderen Anforderungen genügen. Üblicherweise wird das Drehmoment beim Festziehen der Schraubverbindung gemessen, um später eventuelle Reklamationen nachverfolgen zu können. Insbesondere bei sicherheitsrelevanten Bauteilen wird des Weiteren das beim Verschrauben des Gehäuses gemessene Drehmoment dokumentiert und archiviert.

Schraubverbindungen haben des Weiteren den Nachteil, dass sie sich aufgrund der Vibration in dem Fahrzeug lösen können. Die gewünschte Dichtigkeit des versiegelten Gehäuses geht dabei verloren. Im Falle eines Wasserheizers kann das in dem Heizkreislauf geführte Medium durch die Leckage austreten, was zu einer Überhitzung des Systems und zu erheblichen Schäden an dem Gesamtsystem führen kann.

Es besteht zwar die Möglichkeit, den Gehäusedeckel und das Gehäuseunterteil miteinander zu verschweißen oder zu verkleben. Eine solche Verbindung der beiden Gehäuseteile verhindert indes ein einfaches Öffnen des Gehäuses zu Revisions- bzw. Reparaturzwecken. So kann das versiegelte Gehäuse zusammen mit der in dem Gehäuse enthaltenen Vorrichtung üblicherweise nur insgesamt entsorgt werden. Darüber hinaus können nur stoffidentisch ausgebildete Gehäuseteile miteinander verschweißt werden.

Mitunter besteht die Notwendigkeit, das Gehäuse gewichtsparend auszubilden, was die Verwendung von Kunststoff nahelegt. Andererseits aber ist das Gehäuse nahe zu Temperaturquellen angeordnet und/oder kann diese Wärmequellen umgeben und/oder enthalten, was - abhängig von der tatsächlich wirkenden Temperatur - die Verwendung von Kunststoff, zumindest an Teilen des Gehäuses, verhindert. So ist es nicht immer möglich, das Gehäuse stoffidentisch herzustellen.

Insbesondere bei Medien führenden Gehäusen kann es aufgrund des Betriebsdrucks des Mediums zu erheblichen Spannungen an der Fügefläche kommen, die durch eine Schweißverbindung, insbesondere eine Schweißverbindung von Kunststoffen, nicht immer zuverlässig gehalten werden können. So bringt eine Schweißverbindung zwischen den zu fügenden Gehäuseteilen die Gefahr mit sich, dass das Gehäuse bei einem wirkenden Innendruck des in dem versiegelten Gehäuse aufgenommenen und abgeschlossenen Mediums versagt.

Der vorliegenden Erfindung liegt das Problem zugrunde, ein Gehäuse zu schaffen, welches die obigen Nachteile ganz oder teilweise vermeidet. Dabei will die vorliegende Erfindung ein Gehäuse schaffen, das sich leicht und wirtschaftlich herstellen lässt und darüber hinaus geeignet sein soll, zu Revisions- bzw. Reparaturarbeiten zerstörungsfrei geöffnet zu werden. Die vorliegende Erfindung will ferner ein Verfahren zur Herstellung eines versiegelten Gehäuses einer in ein Kraftfahrzeug einzubauenden Vorrichtung angeben.

Zur Lösung des vorrichtungsmäßigen Aspekts wird mit der vorliegenden Erfindung ein versiegeltes Gehäuse mit den Merkmalen von Anspruch 1 vorgeschlagen.

Das erfindungsgemäße versiegelte Gehäuse hat ein längliches Formschlusselement, durch welches das Gehäuseunterteil und der Gehäusedeckel formschlüssig miteinander verbunden sind. Das Formschlusselement ist zwischen einander gegenüberliegenden Anlageflächen für das Formschlusselement von Gehäuseunterteil und Gehäuseoberteil vorgesehen. Es kann die besagten Anlageflächen von Gehäuseunterteil und Gehäuseoberteil ein- oder beidseitig überragen, d.h. die entsprechenden Anlageflächen einrahmen und in sich aufnehmen. Es kann aber alternativ auch ebenso gut lediglich ausschließlich zwischen den einander gegenüberliegenden Anlageflächen von Gehäuseunterteil und Gehäusedeckel vorgesehen sein.

Das Formschlusselement liegt ferner an den Anlageflächen unter einer Vorspannkraft an. Diese Vorspannkraft ist durch die Kompression des Dichtelementes bewirkt. Dementsprechend hält das Formschlusselement nicht lediglich die beiden Gehäuseteile, d.h. Gehäuseunterteil und Gehäusedeckel zusammen und legt diese relativ zueinander formschlüssig fest. Das Formschlusselement bewirkt vielmehr auch eine Gegenkraft, die der gewünschten Expansion des Dichtelementes entgegenwirkt und dieses komprimiert hält, so dass die beiden Gehäuseteile unter Zwischenlage des komprimierten Dichtelementes versiegelt gegeneinander festgelegt sind. Dabei wird durch angemessene Anpassung des Formschlusselementes einerseits sowie der Anlageflächen von Gehäuseunterteil und Gehäusedeckel andererseits sowie des Weiteren durch die angemessene Dimensionierung des Dichtelementes dafür Sorge getragen, dass etwaige Fertigungsschwankungen durch unterschiedliche Kompression des Dichtelementes ausgeglichen werden können, ohne das zu befürchten ist, dass die Versiegelung des Gehäuses verloren geht. Versiegelt ist hierbei insbesondere eine zumindest von dem Gehäuseunterteil umgebene Kammer zur Aufnahme beispielsweise des Fluids oder der elektronischen Bauteile.

Das längliche Formschlusselement und damit die gegenüberliegenden Anlageflächen erstreckt sich dabei üblicherweise parallel zu einer Fuge, die zwischen dem Gehäuseunterteil und dem Gehäusedeckel gebildet ist und welche durch das Dichtelement abgedichtet wird. Das Dichtelement läuft dabei in Umfangsrichtung umfänglich und geschlossen um, so dass die durch das Gehäuseunterteil umgebene Kammer gegenüber der Umgebung abgedichtet ist. Das längliche Formschlusselement erstreckt sich dabei üblicherweise lediglich entlang einer einzigen, üblicherweise geradlinig verlaufenden Längswand des Gehäuses. Das längliche Formschlusselement hat dementsprechend vorzugsweise eine geradlinige Ausgestaltung, d.h. verläuft parallel zu der zugeordneten Seitenwand.

Zur Versiegelung des Gehäuses reicht ein einziges längliches Formschlusselement aus. Dieses hat üblicherweise in etwa die Erstreckung entsprechend der Länge der zugeordneten Seitenwand des Gehäuses. An der gegenüberliegenden Seitenwand des Gehäuses kann der Gehäusedeckel mit dem Gehäuseunterteil beispielsweise durch ein Scharnier verbunden sein. Denkbar sind auch Rastverbindungen üblicher Art, durch welche das Gehäuseunterteil und der Gehäusedeckel an der dem Formschlusselement gegenüberliegenden Seite verbunden sind. Diese Rastverbindungen sollten so ausgestaltet sein, dass eine gewisse Verschwenkbewegung zwischen dem Gehäuseunterteil und dem Gehäusedeckel um die Rastverbindung möglich ist.

Das längliche Formschlusselement kann durch einen einfachen Stab, insbesondere einen Zylinderstab gebildet sein. Auf die Querschnittsform des im wesentlichen zylindrischen Formschlusselementes kommt es nicht so sehr an. Wesentlich ist eine Anpassung des länglichen Formschlusselementes an die Oberflächengestaltung der Anlagefläche.

Das längliche Formschlusselement wird durch die Vorspannkraft des Dichtelementes zwischen den Anlageflächen kraft- bzw. reibschlüssig gehalten. Die hierbei auf das längliche Formschlusselement wirkende Reibkraft verhindert üblicherweise eine Gleitbewegung des länglichen Formschlusselementes in seiner Längsrichtung.

Allerdings werden mit Blick auf die im Fahrzeug herrschenden Vibrationen weitere Maßnahmen vorgeschlagen, die Handhabung des versiegelten Gehäuses beim Schließen und einen dauerhaften Verschluss des versiegelten Gehäuses mit dem Formschlusselement verbessern.

So ist das längliche Formschlusselement vorzugsweise durch sich quer zu dem länglichen Formschlusselement erstreckende Halteflächen formschlüssig gehalten. Diese Halteflächen ragen von den Anlageflächen des Gehäuseunterteils bzw. des Gehäusedeckels ab und befinden sich üblicherweise an der Außenseite des länglichen Formschlusselementes. Dementsprechend wird das längliche Formschlusselement durch die Halteflächen zwischen der Außenwand des Gehäuses und den Halteflächen formschlüssig gehalten.

Die Halteflächen zu dem an dem Gehäuseunterteil vorgesehenen Anlageflächen ragen üblicherweise von dem Gehäuseunterteil in Richtung auf den Gehäusedeckel ab. In entsprechender Weise ragen alternativ oder ergänzend an dem Gehäusedeckel vorgesehene Halteflächen von den zugeordneten Anlageflächen in Richtung auf das Gehäuseunterteil ab. Damit ist eine formschlüssige Aufnahme des länglichen Formschlusselementes in einer Richtung quer zur Längserstreckung desselben bewirkt. Das längliche Formschlusselement ist dementsprechend zwischen den Halteflächen und der Gehäusewand formschlüssig festgelegt.

Der Gehäusedeckel ist vorzugsweise aus einem gut wärmeleitfähigen Material, insbesondere einem Metall und besonders bevorzugt mittels Druckguss hergestellt. Der Gehäusedeckel kann beispielsweise aus Kupfer oder Aluminium gebildet sein und zumindest eine Heizrippe ausbilden, die eine elektrische Heizvorrichtung in sich aufnimmt. Auch ein mit gut wärmeleitendem Füllstoff gefüllter Kunststoff ist ein gut wärmeleitender Werkstoff im Sinne der vorliegenden Erfindung. Ein solcher aus einem gut wärmeleitenden Material gebildeter Gehäusedeckel ist vorzugsweise in der erfindungsgemäßen Art mit einem Gehäuseunterteil aus Kunststoff verbunden. Sofern ein solches Gehäuseunterteil aus Kunststoff mit einem Gehäusedeckel aus Aluminium kombiniert und verschlossen wird, ergibt sich ein relativ leichter Aufbau der sich besonders gut für ein gewichtssparendes Gehäuse einer elektrischen Heizvorrichtung in einem Kraftfahrzeug eignet.

Gemäß einer bevorzugten Weiterbildung der vorliegenden Erfindung ist das Formschlusselement in seiner Längsrichtung formschlüssig gehalten. Hierzu kann nach dem Einführen des Formschlusselementes durch Verschieben in seiner Längsrichtung vor- und/oder hinter dem länglichen Formschlusselement, d.h. in seiner axialen Verlängerung ein Vorsprung vorgesehen sein oder auch angeordnet werden. Dieser Vorsprung kann durch das Gehäuseunterteil bzw. den Gehäusedeckel ausgebildet werden. Denkbar ist auch die Ausgestaltung durch ein weiteres Bauteil des versiegelten Gehäuses, beispielsweise durch Außenflächen eines Steuergehäuses, welches mit dem Gehäuseunterteil und/oder dem Gehäusedeckel verbunden ist und Steuerkomponenten in sich aufnimmt, die auf in oder auf dem versiegelten Gehäuse vorgesehene Einrichtungen einwirken. Die formschlüssige Halterung kann aber auch durch einen Vorsprung, eine Ausnehmung oder eine Nocke an dem länglichen Formschlusselement gebildet sein, die mit einer Anlagefläche oder einer der Anlagefläche zugeordneten Ausnehmung zusammenwirkt, um das längliche Formschlusselement in Längsrichtung formschlüssig festzulegen.

Gemäß einer bevorzugten Weiterbildung der vorliegenden Erfindung haben das Gehäuseunterteil und der Gehäusedeckel ineinander greifende Befestigungsabschnitte. Diese Befestigungsabschnitte sind in Erstreckungsrichtung des Formschlusselementes alternierend und hintereinander vorgesehen. Dementsprechend wechseln sich Befestigungsabschnitte des Gehäuseunterteils mit Befestigungsabschnitten des Gehäusedeckels ab. Die Befestigungsabschnitte der unterschiedlichen Gehäuseteile verzahnen sich dementsprechend in Erstreckungsrichtung des Formschlusselementes. Diese Befestigungsabschnitte bilden die Anlageflächen aus. Dabei erfolgt die Ausbildung derart, dass die durch das Gehäuseunterteil gebildete Anlagefläche eine durch den Gehäusedeckel gebildete und an dem Befestigungsabschnitt des Gehäusedeckels vorgesehene Anlagefläche überragt. Bei dieser Anschauung wird davon ausgegangen, dass das Gehäuse auf einer durch das Gehäuseunterteil gebildeten Stellfläche steht und der Gehäusedeckel das Gehäuseoberteil oberseitig abdeckt.

Wie bereits vorerwähnt, befindet sich das Formschlusselement üblicherweise an der Außenseite des Gehäuses unmittelbar benachbart zu dessen Außenwand. Hierzu ragen von den Befestigungsabschnitten vorzugweise Befestigungsköpfe ab, die die Anlageflächen ausbilden. Diese Befestigungsköpfe überragen die Außenfläche des üblicherweise glatten und ebenen Gehäuses.

Mit Blick auf eine gewünschte formschlüssige Halterung des länglichen Formschlusselementes in einer Richtung quer zu seiner Erstreckungsrichtung sind die Befestigungsköpfe von Gehäuseunterteil und/oder Gehäusedeckel dabei hakenförmig ausgebildet. Der an dem Gehäuseunterteil vorgesehene Befestigungskopf hat dadurch einen die Anlagefläche überragenden und in Richtung auf das Gehäuseunterteil vorspringenden Verriegelungszapfen. Der an dem Gehäusedeckel zusätzlich oder alternativ vorgesehene Befestigungskopf hat einen die Anlagefläche dieses Verriegelungszapfens überragenden und in Richtung auf den Gehäusedeckel vorspringenden Verriegelungszapfen. Durch die Verriegelungszapfen ist eine Anlagefläche gebildet, die das längliche Verriegelungselement auf seiner dem Gehäuse abgewandten Seite übergreift. So wird durch die Befestigungsköpfe das längliche Verriegelungselement formschlüssig zwischen der Gehäusewandung und dem Verriegelungszapfen geklemmt und die Verriegelungszapfen bilden dabei auf ihrer dem Formschlusselement zugewandten Seite die zuvor beschriebenen Halteflächen aus.

Gemäß einem alternativen Lösungsvorschlag, der in dem nebengeordnete Anspruch 7 angegeben ist, sind mehrere Verriegelungsköpfe und ein Verriegelungsschieber vorgesehen. Der Verriegelungsschieber bildet bei diesem Ausführungsbeispiel das längliche Formschlusselement im Sinne der vorliegenden Erfindung. Die Verriegelungsköpfe sind durch eine Einbringöffnung hindurchführbar, die an dem Verriegelungsschieber und/oder dem Gehäuseunterteil bzw. dem Gehäusedeckel ausgespart sind. Folglich sind die Einbringöffnungen so dimensioniert, dass die Verriegelungsköpfe durch die Einbringöffnungen hindurchpassen. An die Einbringöffnungen schließen sich Verriegelungsöffnungen an. Diese Verriegelungsöffnungen haben eine lichte Weite, die geringer ist als diejenigen der Einbringöffnungen. Die Verriegelungsköpfe sind dementsprechend so dimensioniert, dass die in den Verriegelungsöffnungen aufgenommenen Verriegelungsköpfe in einer Richtung quer zur Erstreckungsrichtung des länglichen Formschlusselementes formschlüssig gehalten sind. Die Verriegelungsköpfe haben dazu vorzugsweise einen die Anlagefläche überragenden Verriegelungsvorsprung, der die zuvor diskutierte Haltefläche in der jetzt beschriebenen bevorzugten Ausgestaltung ausbildet. Der Verriegelungsvorsprung übergreift bei in der Verriegelungsöffnung aufgenommenem Verriegelungskopf die Verriegelungsöffnung und führt somit zu einer formschlüssigen Sicherung des länglichen Formschlusselementes gegenüber dem Gehäuse auf der dem Gehäuse abgewandten Seite des Formschlusselementes.

Mit Blick auf eine formschlüssige Sicherung des länglichen Formschlusselementes in seiner Haupterstreckungsrichtung ist vorzugsweise zwischen der Einbringöffnung und der Verriegelungsöffnung ein die Verriegelungsöffnung überragender Rastnocken vorgesehen. Dieser Rastnocken ist derart ausgebildet, dass er bei in der Verriegelungsöffnung aufgenommenem Verriegelungskopf den Verriegelungskopf hintergreift, so dass eine unbeabsichtigte Verschiebung des länglichen Formschlusselementes durch formschlüssige Anlage des Verriegelungskopfes gegenüber dem Rastnocken unterbleibt. Vorzugsweise ist zwischen jeder Einbringöffnung und der ihr zugeordneten Verriegelungsöffnung ein solcher Rastnocken vorgesehen. Sämtliche Einbring- und Verriegelungsöffnungen sind dabei vorzugsweise identisch ausgebildet und haben identischen Querabstand zueinander.

Mit Blick auf eine möglichst dünnwandige Ausgestaltung von Gehäuseunterteil und Gehäusedeckel und einer einfachen Herstellung des länglichen Formschlusselementes wird gemäß einer bevorzugten Weiterbildung der vorliegenden Erfindung vorgeschlagen, die Verriegelungsköpfe an dem Gehäuseunterteil und dem Gehäusedeckel vorzusehen und zwar derart, dass diese eine Außenfläche des Gehäuses überragen. Die Einbring- und Verriegelungsöffnungen sind an dem Verriegelungsschieber ausgespart, der das längliche Formschlusselement der vorliegenden Erfindung ausbildet. Der längliche Verriegelungsschieber ist in seiner einfachen Ausgestaltung demnach durch einen Blechstreifen gebildet, der zur Ausformung der Einbring- und Verriegelungsöffnungen stanzbearbeitet ist. Neben diesen Öffnungen kann der Verriegelungsschieber weitere Öffnungen aufweisen. Diese dienen einerseits der Gewichtsreduzierung. Andererseits ist es möglich, die Klauen eines Schiebewerkzeuges in dieser weiteren Öffnungen einzubringen, um den Verriegelungsschieber nach Einbringen der Verriegelungsköpfe in die Einbringöffnungen längs zu verschieben und die Formschlussverbindung unter Kompression des Dichtelementes herzustellen.

Bevorzugte Weiterbildungen des versiegelten Gehäuses sind in den Ansprüchen 11 bis 13 angegeben. Soweit der Gegenstand nicht zuvor bereits diskutiert worden ist, erfolgt die Erläuterung hierzu in der speziellen Beschreibung.

Das erfindungsgemäße Gehäuse kann dementsprechend einfach versiegelt werden ohne die Notwendigkeit, Schrauben festzuziehen. Durch angepasste Ausgestaltung der Anlageflächen und des Formschlusselementes kann denkbaren Fertigungstoleranzen Rechnung getragen werden. Wird innerhalb der vorbestimmten Fertigungstoleranzen bei der Herstellung der einzelnen Komponenten gearbeitet, was bei der Herstellung der Komponenten dokumentiert werden kann, so geben die hierdurch gebildeten definierten Formschlussverbindungen innerhalb der gegebenen Toleranzen zwingend vor, die die vorbestimmte Dichtigkeit erfüllt ohne dass es zu Montagefehlern durch beispielsweise übermäßiges oder zu geringes Anziehen von Befestigungselementen wie Schrauben oder dergleichen kommen kann.

Mit Blick auf das verfahrensmäßige Problem wird mit der vorliegenden Erfindung ein Verfahren zum Herstellen eines versiegelten Gehäuses einer in ein Kraftfahrzeug einzubauenden Vorrichtung beschieben. Bei der Vorrichtung handelt es sich insbesondere um eine Heizvorrichtung. Das Gehäuse hat ein Gehäuseunterteil und einen Gehäusedeckel, die - in der zuvor beschriebenen Weise - unter Zwischenlage des Dichtelementes aneinander anliegen.

Bei dem erfindungsgemäßen Verfahren werden zunächst das Gehäuseunterteil und der Gehäusedeckel als separate Bauteile hergestellt. Dann werden Gehäuseunterteil und Gehäusedeckel unter Zwischenlage und unter Kompression des Dichtelementes gegeneinander angelegt. Zur Kompression des Dichtelementes wird dabei eine äußere Kraft auf das Gehäuseunterteil bzw. den Gehäusedeckel aufgebracht. Diese Verfahrensschritte sind aus der DE 196 42 442 A1 bekannt.

Die Kompression des Dichtelementes durch die äußere Kraft ist dabei dem erfindungsgemäßen Vorgehen stärker als die Kompression des Dichtelementes nach dem Fügen von Gehäuseunterteil und Gehäuseoberteil, d.h. nach Herstellen der Formschlussverbindung zwischen dem Gehäuseunterteil und dem Gehäusedeckel. Hierzu wird ein längliches Formschlusselement zwischen die einander gegenüberliegenden Anlageflächen von Gehäuseunterteil und Gehäusedeckel eingebracht. Das längliche Formschlusselement wird hierbei üblicherweise in seiner Erstreckungsrichtung längs verschoben und zwischen die einander gegenüberliegenden Anlageflächen gebracht. Die Haupterstreckungsrichtung des länglichen Formschlusselementes entspricht dabei der Haupterstreckungsrichtung des Dichtelementes. Mit anderen Worten ist im Grunde eine Parallelität zwischen der Erstreckungsrichtung des länglichen Formschlusselementes und der Erstreckungsrichtung des Dichtelementes zu bevorzugen. Das Dichtelement kann zwar auf verschiedenen Ebenen vorgesehen sei, die jeweils die Haupterstreckungsrichtung vorgeben und zwischen den Ebenen können Rampenabschnitte vorgesehen sein. Solche Rampenabschnitte werden aber bei der Ausgestaltung der Abdichtung zwischen dem Gehäuseunterteil und dem Gehäusedeckel nur einen relativ geringen Anteil der umlaufenden Dichtung einnehmen. Idealerweise erstreckt sich das Dichtelement lediglich in einer Ebene, die rechtwinklig zu der Fügerichtung von Gehäuseunterteil und Gehäusedeckel ist und zu der rechtwinklig die äußere Kraft aufgebracht wird. Nachdem das längliche Formschlusselement in seine endgültige Position verbracht worden ist, in welcher das längliche Formschlusselement mit den Anlageflächen zusammenwirkt und üblicherweise sämtliche Anlageflächen überdeckt, wird das Gehäuseunterteil bzw. der Gehäusedeckel von der äußeren Kraft entlastet. Hierdurch legen sich die Anlageflächen unter Vorspannung des Dichtelementes an das längliche Formschlusselement an. Mit anderen Worten bewirkt das längliche Formschlusselement durch Formschluss eine Haltekraft, die der Kraft des Dichtelementes entgegenwirkt, mit welcher das Dichtelement Gehäuseunterteil und Gehäusedeckel auseinanderdrücken will. Danach ist eine formschlüssige und dichte Verbindung zwischen den Gehäuseteilen geschaffen. Das Gehäuse ist versiegelt und zwar über einen Formschluss.

Die äußere Kraft kann beispielsweise durch einen Pressstempel aufgebracht werden, der den Gehäusedeckel gegen das Gehäuseunterteil unter Kompression des Dichtelementes anpresst. Dadurch werden die einander gegenüberliegenden Anlageflächen stärker voneinander beabstandet als im montierten Zustand. Das längliche Formschlusselement kann somit mit Spiel oder lediglich mit geringer Reibkraft an den gegenüberliegenden Anlageflächen vorbei zwischen die Anlageflächen hineingeführt werden. Diese Einführbewegung erfolgt in Längsrichtung des länglichen Formschlusselementes.

Das erfindungsgemäße Verfahren lässt sich danach besonders einfach durchführen und es ergibt sich eine einfache und zuverlässige Abdichtung des Gehäuses.

Darüber hinaus besteht die Möglichkeit, das Gehäuse ganz oder teilweise aus leichtem und kostengünstig herzustellenden Kunststoff auszubilden. Sofern das Gehäuse wärmebeaufschlagte Teile hat, können mit der erfindungsgemäßen Formschlussverbindung auf einfache Weise Gehäuseteile unterschiedlicher stofflicher Beschaffenheit gefügt und fluiddicht miteinander verbunden werden, auch dann, wenn in dem versiegelten Gehäuse ein erheblicher Innendruck herrscht. Das erfindungsgemäße Gehäuse ist auch dann dicht, wenn ein Innendruck von bis zu 3 bar, bevorzugt von bis zu 5 bar herrscht. Diese Dichtigkeit wird üblicherweise in dem erfindungsgemäßen versiegelten Gehäuse bewirkt ohne dass Schrauben oder andere, manuell oder maschinell anzuziehende Befestigungsmittel zum Einsatz kommen. Das versiegelte Gehäuse hat üblicherweise überhaupt keine Schrauben. Sämtliche Verbindungen jedenfalls zwischen dem Gehäuseunterteil und dem Gehäusedeckel werden üblicherweise mittels Formschluss hergestellt und gehalten. Auch die übrigen Verbindungen an dem versiegelten Gehäuse sind vorzugsweise ausschließlich als Formschlusselemente ausgeformt.

Weitere Einzelheiten und Vorteile der vorliegenden Erfindung ergeben sich aus der nachfolgenden Beschreibung von Ausführungsbeispielen in Verbindung mit der Zeichnung. In dieser zeigen:
- Figur 1: eine perspektivische Seitenansicht eines ersten Ausführungsbeispiels eines versiegelten Gehäuses;
- Figur 2: ein vergrößertes Detail in perspektivischer Seitenansicht des in Figur 1 gezeigten Ausführungsbeispiels;
- Figur 3: eine Querschnittsansicht des in den Figuren 1 und 2 gezeigte Ausführungsbeispiel;
- Figur 4: eine Längsschnittansicht des ersten Ausführungsbeispiels mit einem aufgesetzten Steuergehäuse;
- Figur 5: eine Ansicht gemäß Figur 1 eines zweiten Ausführungsbeispiels;
- Figur 6: eine Längsschnittansicht eines Gehäuseunterteils eines dritten Ausführungsbeispiels;
- Figur 7: eine perspektivische Seitenansicht gemäß Figuren 1 bzw. 6 eines vierten Ausführungsbeispiels;
- Figur 8: das in Figur 7 gezeigte Ausführungsbeispiel vor dem endgültigen Fügen des Gehäuses;
- Figur 9: die Darstellung nach Figur 8 nach dem endgültigen Fügen des Gehäuses; und
- Figur 10: eine perspektivische Schnittansicht entlang der Linie X-X gemäß Figur 9;

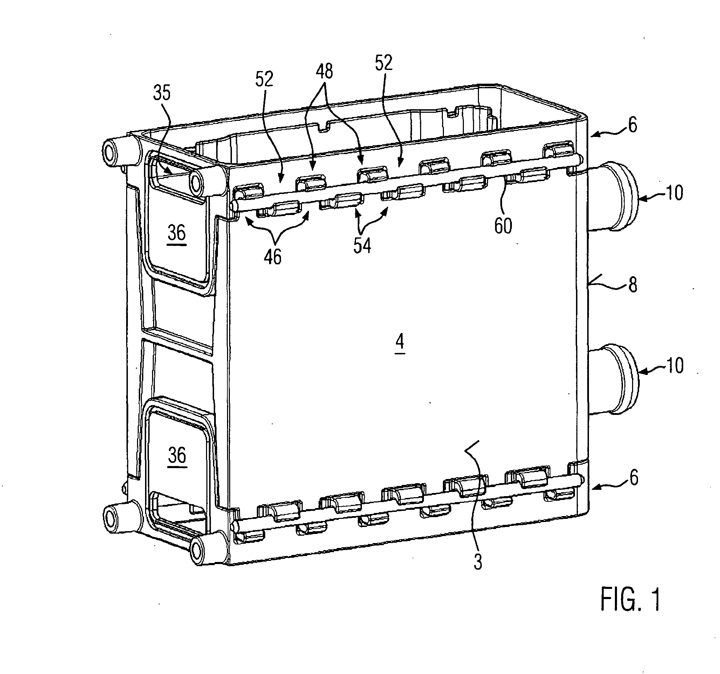

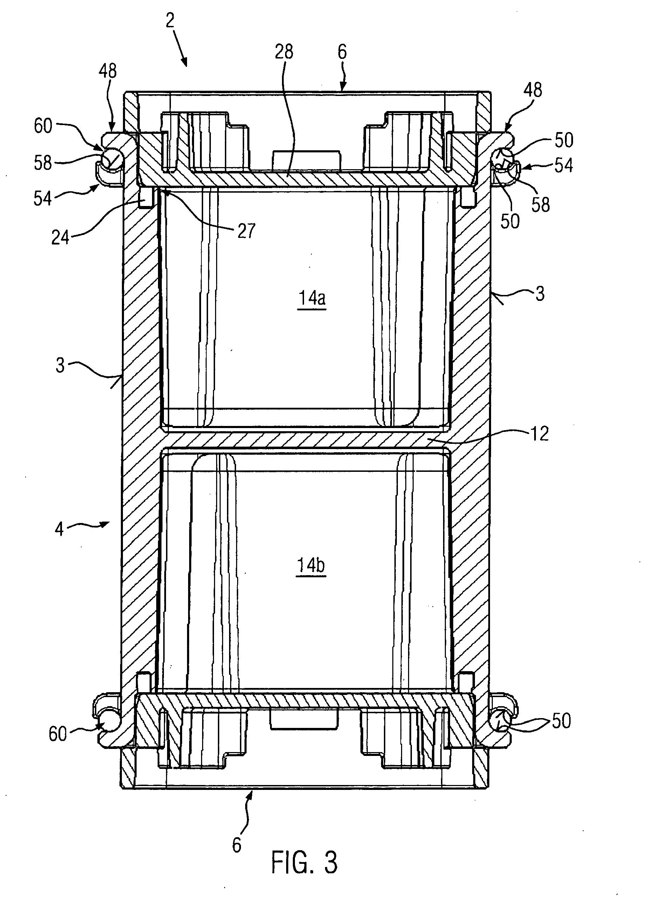

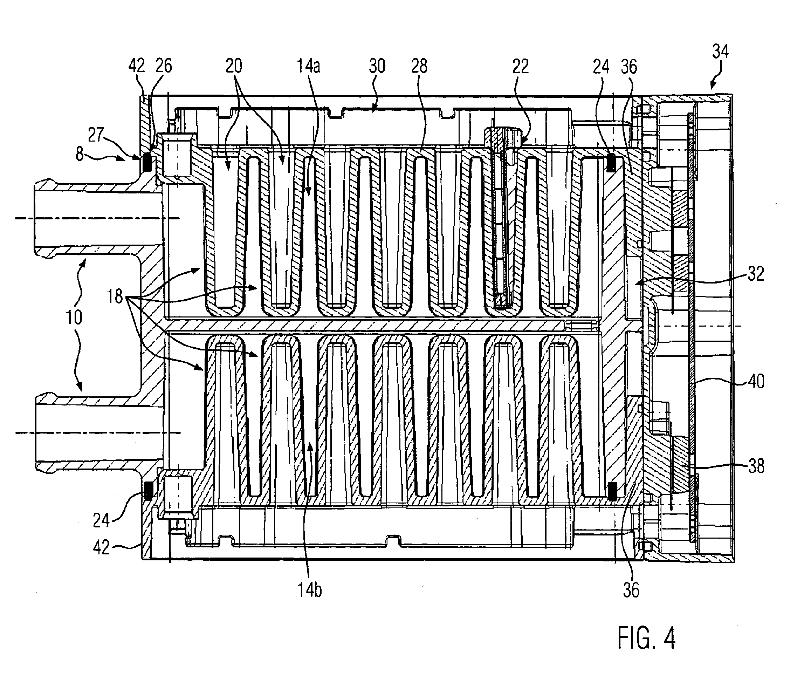

Die Figur 1 zeigt eine perspektivische Ansicht eines versiegelten Gehäuses 2 mit einer ebenen, geradlinig verlaufenden Außenwand 3, welches vorliegend dreiteilig mit einem Gehäuseunterteil 4 und zwei einander gegenüberliegenden Gehäusedeckeln 6 ausgebildet ist. Die Gehäusedeckel 6 sind jeweils identisch ausgeformt und als Aluminium-Druckgussbauteile hergestellt. Das Gehäuseunterteil 4 ist ein spritzgegossenes Kunststoffbauteil, dessen erste Stirnseite 8 von zwei sich parallel erstreckenden Anschlussstutzen 10 überragt ist. Wie insbesondere aus Figuren 3 und 4 ersichtlich, bildet das Gehäuseunterteil 4 diese Anschlussstutzen 10 einteilig und einteilig auch eine mittige Trennwand 12 aus, die zwei Zirkulationskammern 14a, 14b voneinander trennt, die über einen Strömungsdurchgang 16, der in der Trennwand ausgespart ist, miteinander kommunizieren, so dass eine Strömung von dem einen Anschlussstutzen 10 durch die zugeordnete Zirkulationskammer 14a, durch den Strömungsdurchgang 16 und die andere Zirkulationskammer 14b möglich ist, die durch den anderen Anschlussstutzen 10 aus dem Gehäuse 2 herausgeleitet wird.

Der Gehäusedeckel 6 ist bei dem gezeigten Ausführungsbeispiel nicht nur als Abdeckung für die Zirkulationskammer 14a, 14b vorgesehen. Vielmehr bildet der Gehäusedeckel 6 auch Heizrippen 18 mit jeweils U-förmigen Ausnehmungen 20 aus. In diese U-förmigen Ausnehmungen 20 sind elektrische Heizelemente eingesetzt. In Figur 4 ist ein PTC-Heizelement 22 dargestellt, welches in der in EP 1 872 986 A1 bzw. der EP 1 921 896 A1 beschriebenen Weise ausgestaltet und in der beispielsweise in EP 2 440 004 A1 beschriebenen Weise in der U-förmigen Ausnehmung 20 aufgenommen ist. Bezüglich der konkreten Ausgestaltung des PTC-Heizelementes 22 und der Anordnung innerhalb der U-förmigen Ausnehmungen 20 wird auf die Offenbarung der zuvor genannten Offeniegungsschriften der vorliegenden Anmelderin verwiesen, deren Offenbarungsgehalt insofern in die Offenbarung der vorliegenden Anmeldung durch Bezugnahme aufgenommen wird.

Wie ferner die Schnittdarstellungen nach den Figuren 3 und 4 erkennen lassen, liegt der Gehäusedeckel 6 unter Zwischenlage eines Dichtelementes 24 an dem Gehäuseunterteil 4 an. Das Dichtelement 24 ist in einer an dem Gehäuseunterteil 4 ausgesparten Nut 26 eingebracht und dort gehalten. Das Dichtelement 24 überragt eine stirnseitige Endfläche des Gehäuseunterteils 4, auf welche der Gehäusedeckel 6 unter Ausbildung einer Fuge 27 aufgesetzt wird.

Der Gehäusedeckel 6 weist neben den U-förmigen Ausnehmungen 22 eine Trennwand 28 auf, welche die zugeordnete Zirkulationskammer 14 von einer im Wesentlichen von dem Gehäusedeckel 6 umgebenen Anschlusskammer 30 trennt. In dieser Anschlusskammer 30 werden die PTC-Heizelemente 22 in der in EP 2 440 004 A1 beschriebenen Weise mit einer nicht gezeigten Leiterplatte kontaktiert, deren Leiterbahnen bis zu der zweiten Stirnseite 32 und durch eine an der zweiten Stirnseite 32 vorgesehene Öffnung 35 in ein dort vorgesehenes Steuergehäuse 34 geführt sind, wie dies in der EP 2 440 004 A1 bzw. der EP 1 872 986 A1 der vorliegenden Anmelderin beschrieben ist. Deren Offenbarungsgehalt ist insofern dem Offenbarungsgehalt der vorliegenden Anmeldung durch Bezugnahme zuzurechnen.

Wie insbesondere Figur 4 verdeutlicht, hat der Gehäusedeckel 6 einen Anlageschenkel 36, der einteilig an dem Gehäusedeckel 6 ausgeformt ist und der an der zweiten Stirnseite 32 des Gehäuseunterteils 4 freiliegt (vgl. Figuren 1 und 4). Dieser Anlageschenkel 36, der wärmeleitend mit den Heizrippen 18 innerhalb des Gehäuseunterteils 4 verbunden ist, dient als Wärmesenke und Anlagefläche zur Ableitung von Verlustleistung von Leistungstransistoren 38, die innerhalb des Steuergehäuses 34 vorgesehen und an einer Unterseite einer Leiterplatte 40 in einer Weise befestigt und gegen den Anlageschenkel 36 angelegt sind, wie dies im Einzelnen in EP 2 440 004 A1 beschrieben ist. Auch insofern ist der Offenbarungsgehalt der EP 2 440 004 A1 dem Offenbarungsgehalt der vorliegenden Patentbeschreibung hinzuzurechnen.

Der Anlageschenkel 36 liegt an der zweiten Stirnseite 32 frei, d.h. übergreift das Gehäuseunterteil 4 außenseitig und bildet aufgrund der einteiligen Ausgestaltung mit den Heizrippen 18, die von dem in der Zirkulationskammer 14 aufgenommenen Fluid umströmt werden, die Wärmesenke aus.

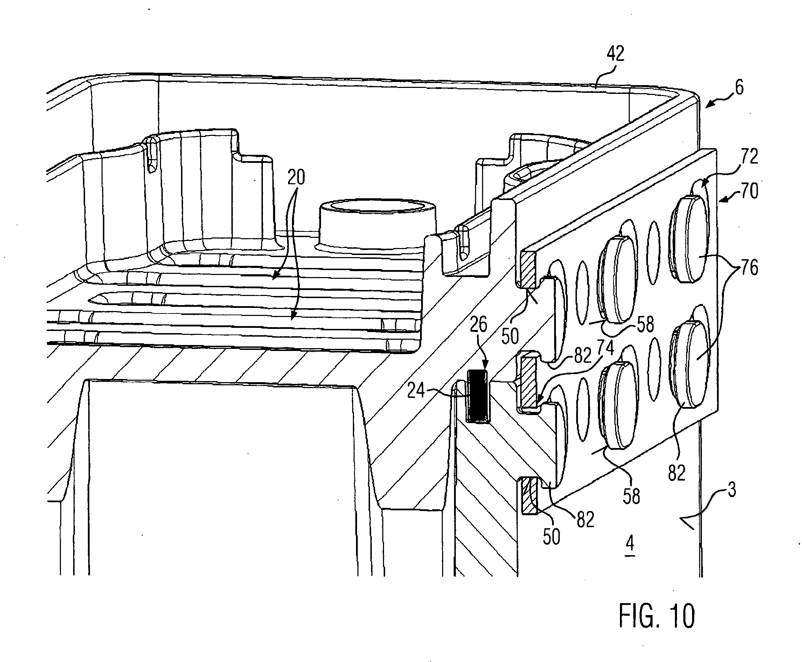

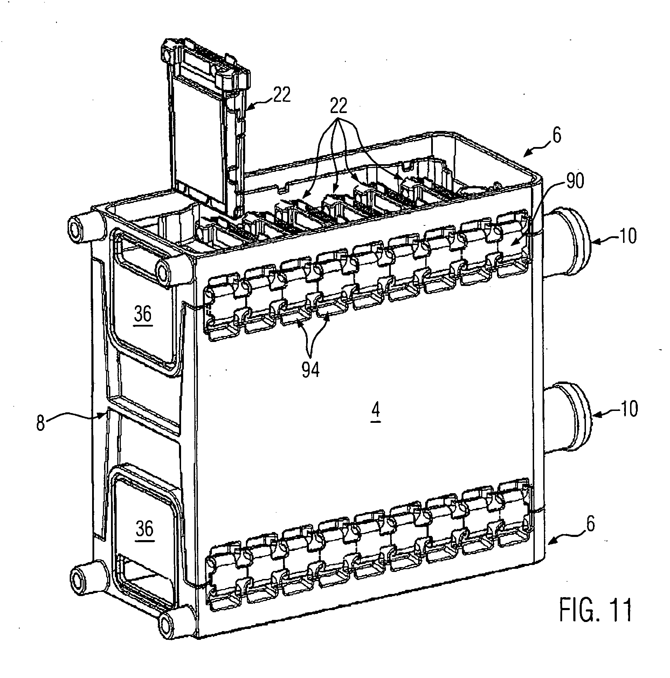

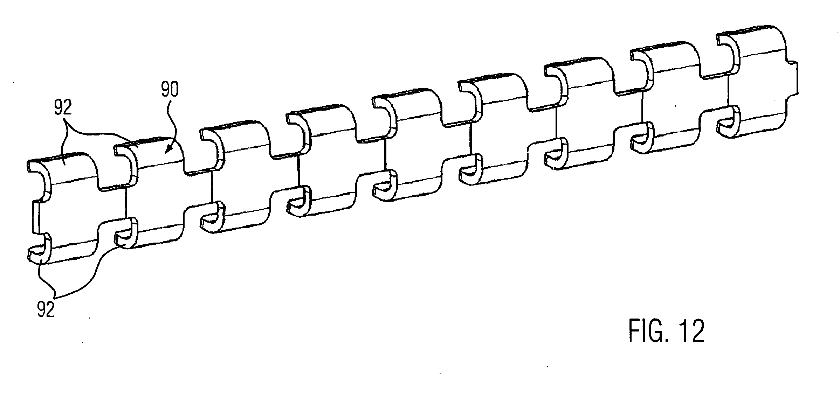

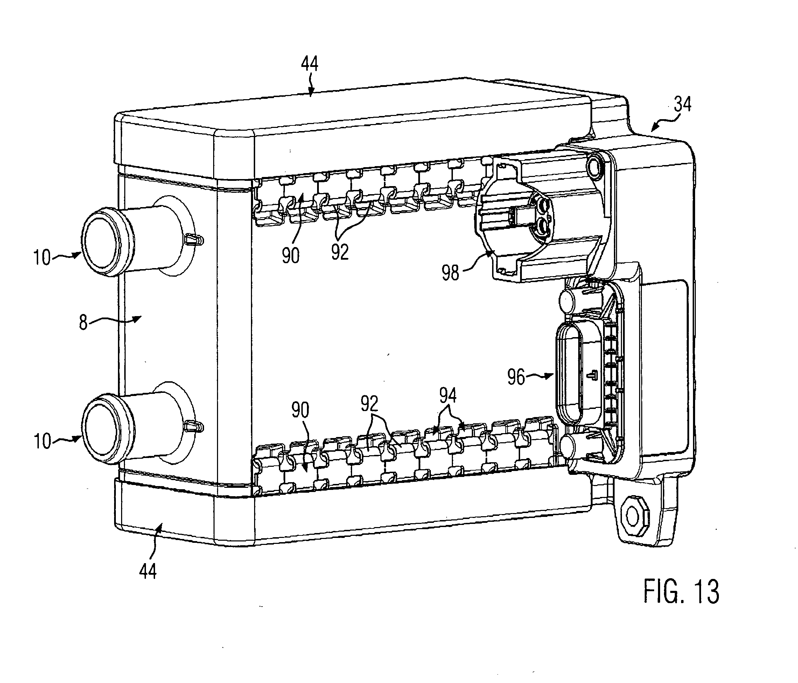

Der Gehäusedeckel 6 hat einen umlaufenden Rand 42(vgl. Figur 10), auf den ein Anschlussdeckel 44 aufclipsbar ist.

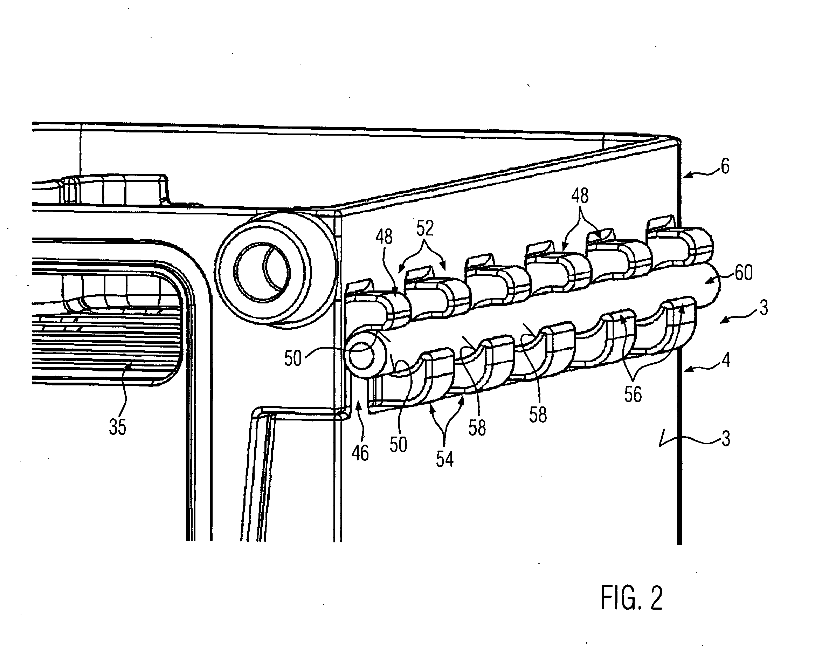

Die fluiddichte Abdeckung des Gehäuseunterteils 4 ergibt sich insbesondere aus den Figuren 1 und 2. Wie aus diesen beiden Figuren ersichtlich, hat das Gehäuseunterteil 4 mehrere mit Abstand zueinander vorgesehene Befestigungsabschnitte 46, die an der Außenwand 3, d.h. Längsseite des Gehäuses 2 zunächst in der Ebene dieser Außenwand 3 vorgesehen sind. Die Befestigungsabschnitte 46 weisen Befestigungsköpfe 48 auf, die die Außenwand 3 überragen und eine sich im Wesentlichen rechtwinklig zu der Außenwand 3 erstreckende Anlagefläche 50 ausbilden.

Auch der Gehäusedeckel 6 hat Befestigungsabschnitte 52, die mit Abstand zueinander vorgesehen sind, derart, dass die Befestigungselemente 46 des Gehäuseunterteils 4 zwischen benachbarte Befestigungsabschnitte 52 des Gehäusedeckels 6 ragen können. Die Befestigungsabschnitte 52 des Gehäusedeckels 6 weisen hakenförmige Befestigungsköpfe 54 auf, die - wie die Befestigungsköpfe 48 des Gehäuseunterteils 4 - Anlageflächen 50 ausformen. Aufgrund der hakenförmigen Ausgestaltung der Befestigungsköpfe 54 bilden diese die Anlageflächen 50 in Richtung auf den Gehäusedeckel 6 vorspringende Verriegelungszapfen 56 aus. Jeder Verriegelungszapfen 56 formt eine Haltefläche 58 aus. Zwischen den einander gegenüberliegenden Anlageflächen 50 des Gehäusedeckels 6 einerseits und des Gehäuseunterteils 4 andererseits ist ein stabförmiges, d.h. zylindrisches und längliches Formschlusselement 60 angeordnet.

Zur Montage des in den Figuren 1 bis 4 gezeigten Ausführungsbeispiels werden zunächst die beiden Gehäuseteile 4, 6 als separate Bauteile hergestellt. Danach wird in die Nut 26 das Dichtelement 24 eingesetzt. Der Gehäusedeckel 6 wird nunmehr auf das Gehäuseunterteil 4 aufgesetzt. Danach wird durch eine äußere Kraft das Dichtelement 24 komprimiert, d.h. die beiden Gehäuseelemente 4, 6 werden gegeneinander gedrückt unter Kompression des Dichtelementes 24. Durch diese Kompression werden die Anlageflächen 50 des Gehäusedeckels 6 einerseits und die Anlageflächen 50 des Gehäuseunterteils 4 andererseits maximal voneinander entfernt. Dann wird das längliche Formschlusselement 60 entlang seiner Längserstreckungsrichtung, d.h. Haupterstreckungsrichtung und damit parallel zu der Außenwand 3 zwischen die Befestigungsköpfe 48, 54 geführt, bis die in den Figuren 1 und 2 gezeigte Endlage erreicht ist. Danach wird die äußere Kraft von dem Gehäuseunterteil bzw. dem Gehäusedeckel entlastet, so dass beide Teile sich aufgrund der entspannenden Kompression des Dichtelementes 24 geringfügig voneinander entfernen, und sich die in Kraftwirkungsrichtung gegenüberliegenden Anlageflächen 50 annähern bis die beiderseitigen Anlageflächen 50 zur Anlage an dem Formschlusselement 60 gelangen. Danach sind die beiden Gehäuseteile 4, 6 formschlüssig unter Kompression des Dichtelementes gefügt. Die von dem Dichtelement 24 bewirkte Vorspannkraft wird von dem Formschlusselement 60 gehalten. Darüber hinaus wird durch die Halteflächen 58 der hakenförmigen Befestigungsköpfe 54 des Gehäusedeckels 6 verhindert, dass das Formschlusselement 60 in einer Richtung im Wesentlichen rechtwinklig zu der Außenwand 3 beispielsweise in Folge von Vibration herauswandern kann. Die hakenförmigen Befestigungsköpfe 54 halten dementsprechend das Formschlusselement 60 formschlüssig in einer sich quer zu dem länglichen Formschlusselement 60 erstreckenden Richtung und verhindert ein Abgleiten des Formschlusselementes 60 von den Anlageflächen 50.

Bei dem gezeigten Ausführungsbeispiel sind an beiden Längsseiten identische Ausgestaltungen zur Aufnahme und Halterung des Formschlusselementes 60 vorgesehen sind.

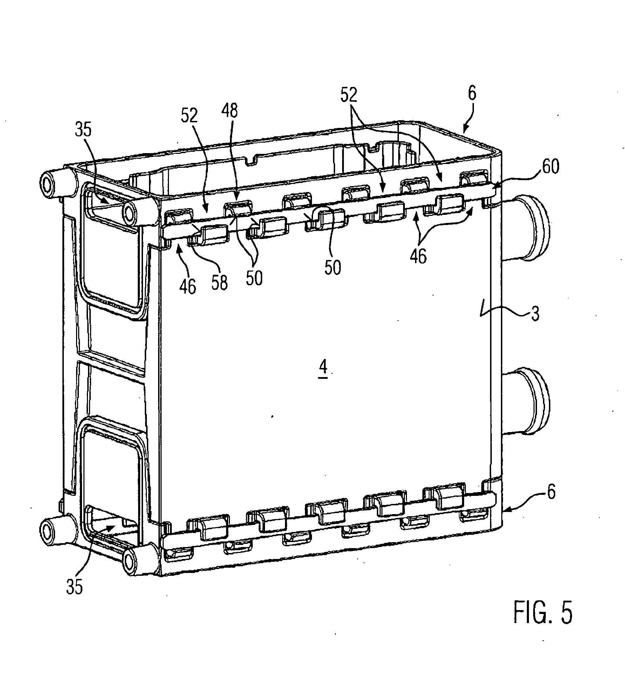

Die Figur 5 zeigt ein gegenüber dem Ausführungsbeispiel nach den Figuren 1 bis 4 leicht abgewandeltes Ausführungsbeispiel. Gleiche Bauteile sind mit gleichen Bezugszeichen gekennzeichnet.

Während bei dem ersten Ausführungsbeispiel das Formschlusselement 60 durch eine zylindrische Stange mit kreisrunden Querschnitt gebildet ist, hat das Formschlusselement 60 nach dem zweiten Ausführungsbeispiel gemäß Figur 5 einen rechteckigen Querschnitt und ist als Rechteckstab vorgesehen. Die hakenförmigen Befestigungsköpfe 54 des Gehäusedeckels 6 sind entsprechend abgewinkelt ausgebildet, so dass die Haltefläche 58 streng rechtwinklig zu der zugeordneten Anlagefläche 50 verläuft. Die Befestigungsköpfe 48 des Gehäuseunterteils 4 ragen im Wesentlichen mit einer sich rechtwinklig zu der Außenwand 3 erstreckenden Anlagefläche 50 von dem zugeordneten Befestigungsabschnitt 46 des Gehäuseunterteils 4 ab.

Wie bei dem ersten Ausführungsbeispiel, so ist auch bei dem zweiten Ausführungsbeispiel das Formschlusselement 60 endseitig an beiden Seiten leicht konisch angefast, wodurch das Einführen des Formschlusselements 60 zwischen die einander gegenüberliegenden Anlageflächen 50 erleichtert wird.

Bei beiden Ausführungsbeispielen liegt das Formschlusselement zwischen der Außenwand 3, welche hier durch die Befestigungsabschnitte 46 bzw. 52 fortgesetzt wird und den Halteflächen 48 formschlüssig fest, die Anlagenflächen 50 verhindern eine Bewegung rechtwinklig hierzu. Nicht gezeigte endseitige Anschläge können nach der Montage montiert werden bzw. zumindest einseitig fest an dem Gehäuseunterteil 4 bzw. dem Gehäusedeckel 6 vorgesehen sein, um eine Längsverschiebung des Formschlusselementes 60 zu verhindern. Ebenso gut kann das Formschlusselement 60 eine Aussparung aufweisen, die mit einem Vorsprung zusammenwirkt, der beispielsweise von der Anlagefläche 50 eines einzigen Befestigungskopfes 48 bzw. 54 abragt, um das Formschlusselement 60 auch in seiner Haupterstreckungsrichtung formschlüssig zu halten und ein Verrutschen bei Vibration unter Nutzungsbedingungen in dem Kraftfahrzeug zu verhindern.

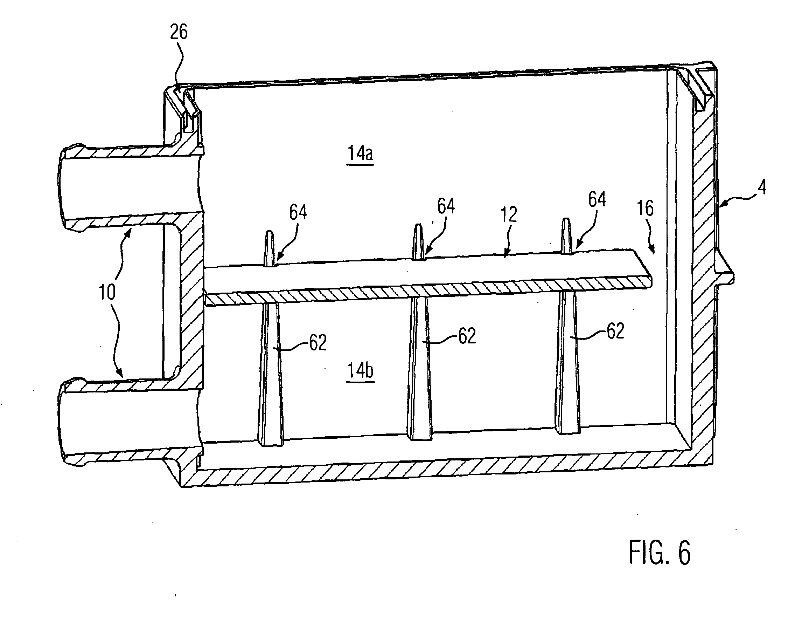

Die Figur 6 zeigt ein Ausführungsbeispiel eines Gehäuseunterteils 4 mit einer zunächst separat hergestellten Trennwand 12. Das Gehäuseunterteil 4 weist in die Zirkulationskammer 14a, 14b hineinragende und von einer Längswand innen abragende konisch zulaufende Auflagerippen 62 auf. Diesen zugeordnet weist die Trennwand 12 Aussparungen 64 auf. Die von oben in das Gehäuseunterteil 4 eingesetzte Trennwand 12 gleitet zunächst über die konischen Auflagerippen 62 ab, wobei aufgrund der Konizität der Auflagerippen 62 ein weiteres Abgleiten der Trennwand 12 verhindert wird. So werden innerhalb des Gehäuseunterteils 4 auf einfache Weise die beiden Zirkulationskammern 14a, 14b abgeteilt. Auf eine vollständige Dichtigkeit zwischen den beiden Kammern kommt es nicht an.

Die zuvor beschriebenen Ausführungsbeispiele nach den Figuren 1 bis 5 beruhen jeweils auf dem Prinzip, dass die Befestigungsabschnitte 46 und 52 jeweils alternierend in Längsrichtung des Formschlusselementes 60 vorgesehen sind und ineinander greifen. Zwischen benachbarten Befestigungsabschnitten 46 des Gehäuseunterteils 4 greifen jeweils benachbarte Befestigungsabschnitte 52 des Gehäusedeckels 6 ein. Die Gehäusedeckel 6 sind identisch. Das Formschlusselement 60 ist im Grunde als unspezifischer zylindrischer Körper ausgebildet und wird über die gesamte Längserstreckung der Außenwand 3 des Gehäuseunterteils eingeschoben. Das Formschlusselement 60 befindet sich in etwa auf Höhe des Dichtelementes 24.

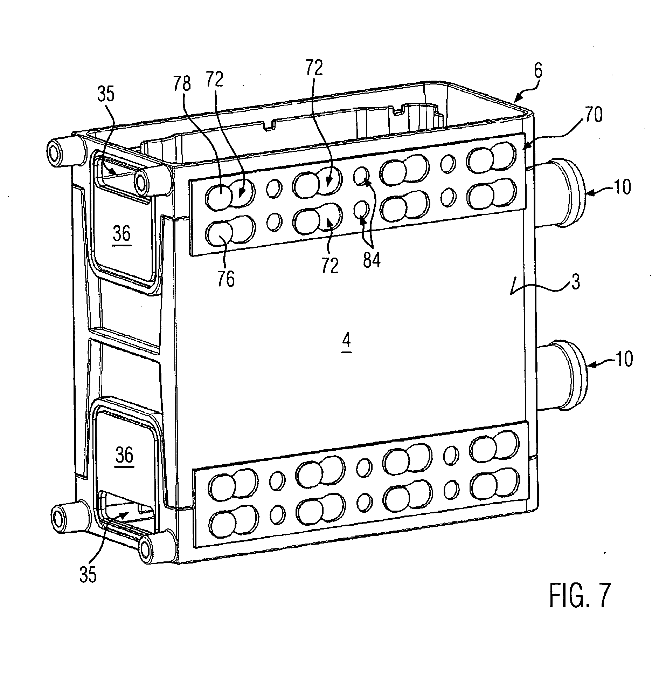

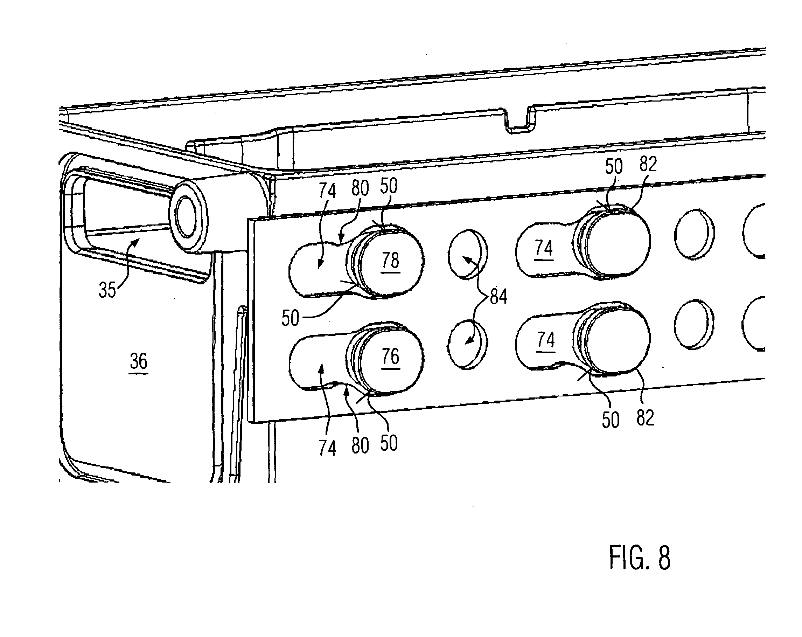

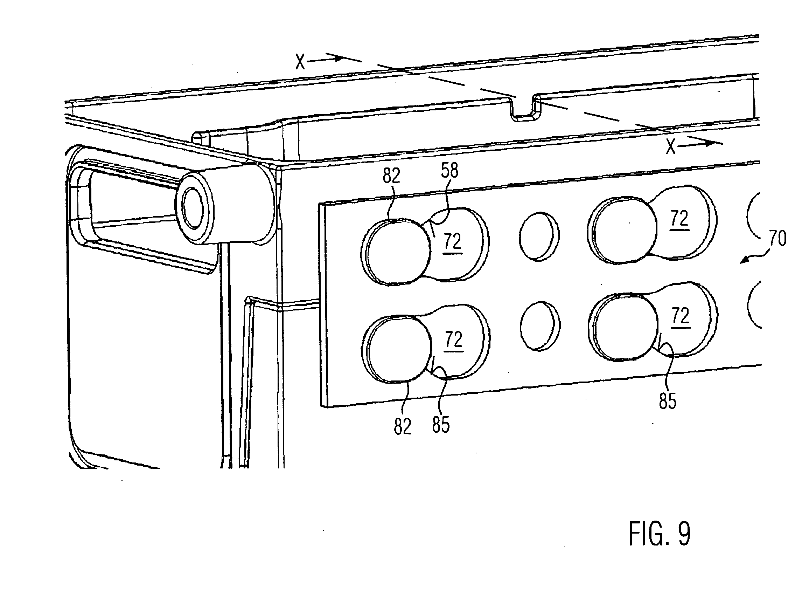

Demgegenüber handelt es sich bei dem Formschlusselement 60 des in den Figuren 7 bis 9 verdeutlichten Ausführungsbeispiels um einen als gestanzten Blechstreifen gebildeten Verriegelungsschieber 70, der ein Ausführungsbeispiel eines länglichen Formschlusselementes bildet. Der Verriegelungsschieber 70 hat Einbringöffnungen 72, die größer als sich an die Einbringöffnungen 72 anschließende Verriegelungsöffnungen 74 sind (vgl. Fig. 8). An dem Gehäuseunterteil 4 sind auf einer Höhe und hintereinander mehrere Verriegelungsköpfe 76 angeordnet. Der Gehäusedeckel 6 hat in gleicher Weise vorgesehene Verriegelungsköpfe 78. Die Verriegelungsköpfe 76 bzw. 78 erstrecken sich über die gesamte Längserstreckung der Außenwand 3.

Zur Montage wird zunächst der Verriegelungsschieber mit seinen Einbringöffnungen 72 fluchtend zu den Verriegelungsköpfen 76, 78 angeordnet. Dann wird der Verriegelungsschieber 70 über die Verriegelungsköpfe 76, 78 herübergeführt, d.h. die Verriegelungsköpfe 76, 78 werden durch die Einbringöffnung 72 hindurchgeführt. Danach liegt der Verriegelungsschieber 70 gegen die Außenwand 3 von Gehäuseunterteil 4 und Gehäusedeckel 6 an.

Danach wird üblicherweise von außen eine äußere Kraft aufgebracht, um Gehäuseunterteil 4 und Gehäusedeckel 6 gegeneinander zu drücken unter Kompression des Dichtelementes 24. Danach wird der Verriegelungsschieber 70 parallel zu der Außenwand 3 verschoben, wodurch die Verriegelungsköpfe 76, 78 in die Verriegelungsöffnungen 74 überführt werden. Zwischen den Verriegelungsöffnungen 74 und den Einbringöffnungen 72 befindet sich ein Nocken 80, der bei in der Verriegelungsöffnung 74 eingebrachten Verriegelungsköpfen 76, 78 die entsprechenden Köpfe 76, 78 hintergreift, so dass nach Entlasten der äußeren Kraft ein unbeabsichtigtes Verschieben des Verriegelungsschiebers 70 verhindert wird. Damit ist der Verriegelungsschieber 70 in Längserstreckung formschlüssig gehalten. Die Verriegelungsköpfe 76, 78 liegen mit ihrer Anlagefläche 50 gegen einen die Verriegelungsöffnung 74 begrenzenden Rand, der durch den Verriegelungsschieber 70 gebildet wird, formschlüssig an. Des Weiteren haben die Verriegelungsköpfe einen die entsprechende Anlagefläche 50 überragenden Verriegelungsvorsprung 82, der wie ein Teller die Anlagefläche 50 überragt und den endseitigen Abschluss der Verriegelungsköpfe 76, 78 bildet. Dieser Verriegelungsvorsprung 82 übergreift die Verriegelungsöffnung 74, so dass verhindert wird, dass der Verriegelungsschieber 70 von den Verriegelungsköpfen 76, 78 in einer Bewegung rechtwinklig zu der Außenwand 3 abgleitet. So bildet der Verriegelungsvorsprung 48 die zuvor bereits diskutierte Haltefläche aus, durch welche der Verriegelungsschieber 70 formschlüssig gehalten ist.

Die Figuren 7 bis 9 lassen zwischen den Einbring- und Verriegelungsöffnungen 72, 74 jeweils weitere Öffnungen 84 erkennen. Hierbei handelt es sich um Eingrifföffnungen für ein Werkzeug, mit dem der Verriegelungsschieber 70 verschoben wird, um die Köpfe 76, 78 von der Einbringöffnung 72 in die Verriegelungsöffnung 74 zu überführen. Bei der Anwendung eines solchen Werkzeuges kann gegebenenfalls darauf verzichtet werden, das Gehäuseunterteil 4 gegenüber dem Gehäusedeckel 6 durch eine äußere Kraft aufzupressen. Durch eine durch die Nocken 80 gebildeten Rampenfläche 85 zwischen der Einbringöffnung 72 und der Verriegelungsöffnung 74 wird das Zusammendrücken der beiden Gehäuseteile 4, 6 bewirkt. Aber auch bei dieser Ausgestaltung wird das Dichtelement dann über die Gebrauchslage hinaus verpresst, wenn die Verriegelungsköpfe 76, 78 den Nocken 80 passieren.

### Bezugszeichenliste

- 2: Gehäuse
- 3: Außenwand
- 4: Gehäuseunterteil
- 6: Gehäusedeckel
- 8: erste Stirnseite
- 10: Anschlussstutzen
- 12: Trennwand
- 14a: Zirkulationskammer
- 14b: Zirkulationskammer
- 16: Strömungsdurchgang
- 18: Heizrippe
- 20: U-förmige Ausnehmung
- 22: PTC-Heizelement
- 24: Dichtelement
- 26: Nut
- 27: Fuge
- 28: Trennwand
- 30: Anschlusskammer
- 32: zweite Stirnseite
- 34: Steuergehäuse
- 35: Öffnung
- 36: Anlageschenkel
- 38: Leistungstransistor
- 40: Leiterplatte
- 40: Leiterplatte
- 42: Rand
- 46: Befestigungsabschnitt Gehäuseunterteil
- 48: Befestigungskopf
- 50: Anlagefläche
- 52: Befestigungsabschnitt Gehäusedeckel
- 54: hakenförmiger Befestigungskopf
- 56: Verriegelungszapfen
- 58: Haltefläche
- 60: Formschlusselement
- 62: Auflagerippen
- 64: Aussparung
- 70: Verriegelungsschieber
- 72: Einbringöffnung
- 74: Verriegelungsöffnung
- 76: Verriegelungskopf
- 78: Verriegelungskopf
- 80: Nocken
- 82: Verriegelungsvorsprung
- 84: Einbringöffnungen
- 85: Rampenfläche

## Patentansprüche

1. Versiegeltes Gehäuse (2) einer in ein Kraftfahrzeug einzubauenden Vorrichtung, insbesondere einer elektrischen Heizvorrichtung, mit einem Gehäuseunterteil (4) und einem Gehäusedeckel (6), der unter Zwischenlage eines Dichtelementes (24) an dem Gehäuseunterteil (4) anliegt,
**gekennzeichnet durch** ein längliches, das Gehäuseunterteil (4) und den Gehäusedeckel (6) formschlüssig miteinander verbindendes Formschlusselement (60, 70), das zwischen einander gegenüberliegenden Anlageflächen (50) von Gehäuseunterteil (4) und einem Gehäusedeckel (6) vorgesehen ist und an den Anlageflächen (50) unter einer **durch** Kompression des Dichtelementes (24) bewirkten Vorspannkraft anliegt.

2. Versiegeltes Gehäuse (2) nach Anspruch 1, **dadurch gekennzeichnet, dass** das längliche Formschlusselement (60, 70) durch sich quer zu dem länglichen Formschlusselement (60, 70) erstreckende, von den Anlageflächen (50) des Gehäuseunterteils (4) bzw. des Gehäusedeckels (6) vorspringende Halteflächen (58) formschlüssig gehalten ist.

3. Versiegeltes Gehäuse (2) nach Anspruch 1 oder 2, **dadurch gekennzeichnet, dass** in axialer Verlängerung des länglichen Formschlusselementes (60, 70) vor und/oder hinter dem länglichen Formschlusselement (60, 70) ein Vorsprung vorgesehen ist, durch den das längliche Formschlusselement (60, 70) in seiner Längsrichtung formschlüssig gehalten ist.

4. Versiegeltes Gehäuse (2) nach einem der vorherigen Ansprüche, **dadurch gekennzeichnet, dass** das Gehäuseunterteil (4) und der Gehäusedeckel (6) ineinandergreifende Befestigungsabschnitte (46, 52) aufweisen, die in Erstreckungsrichtung des länglichen Formschlusselementes (60) alternierend und hintereinander vorgesehen sind und die Anlageflächen (50) ausbilden.

5. Versiegeltes Gehäuse (2) nach Anspruch 4, **dadurch gekennzeichnet, dass** die Befestigungsabschnitte (46, 52) von einer Außenfläche (3) des Gehäuses (2) abragende Befestigungsköpfe (48, 54) aufweisen, die die Anlageflächen (50) ausbilden.

6. Versiegeltes Gehäuse (2) nach Anspruch 5, **dadurch gekennzeichnet, dass** die Befestigungsköpfe (48, 54) hakenförmig ausgebildet sind, wobei der an dem Gehäuseunterteil (4) vorgesehene Befestigungskopf (48) einen die Anlagefläche (50) überragenden und in Richtung auf das Gehäuseunterteil (4) vorspringenden Verriegelungszapfen (56) und/oder der an dem Gehäusedeckel (6) vorgesehene Befestigungskopf (54) einen die Anlagefläche (50) überragenden und in Richtung auf den Gehäusedeckel (6) vorspringenden Verriegelungszapfen (56) aufweist.

7. Versiegeltes Gehäuse (2) einer in ein Kraftfahrzeug einzubauenden Vorrichtung, insbesondere einer elektrischen Heizvorrichtung, mit einem Gehäuseunterteil (4) und einem Gehäusedeckel (6), der unter Zwischenlage eines Dichtelementes (24) an dem Gehäuseunterteil (4) anliegt, **gekennzeichnet durch** mehrere Verriegelungsköpfe (76, 78) und einen als längliches Formschlusselement ausgebildeten Verriegelungsschieber (70), wobei die Verriegelungsköpfe (76, 78) **durch** an dem Verriegelungsschieber (70) und/oder dem Gehäuseunterteil (4) bzw. dem Gehäusedeckel (6) ausgesparte Einbringöffnungen (72) hindurchführbar und **durch** Verschieben des Verriegelungsschiebers (70) in sich an die Einbringöffnungen (72) anschließende Verriegelungsöffnungen (74) einbringbar sind, so dass **durch** das Zusammenwirken der Verriegelungsköpfe (76, 78) mit den Einbringöffnungen (72) eine formschlüssige Verbindung von Gehäuseunterteil (4) und Gehäusedeckel (6) erhalten ist, wobei der Verriegelungsschieber (70) unter einer **durch** Kompression des Dichtelementes (24) bewirkten Vorspannkraft an den Verriegelungsköpfen (76, 78) anliegt.

8. Versiegeltes Gehäuse (2) nach Anspruch 7, **dadurch gekennzeichnet, dass** die Verriegelungsköpfe (76, 78) einen die Anlagefläche (50) überragenden Verriegelungsvorsprung (82) aufweisen und dass die Verriegelungsöffnung (74) derart an den zugeordneten Verriegelungskopf (76, 78) angepasst ist, dass der Verriegelungsvorsprung (82) bei in der Verriegelungsöffnung (74) aufgenommenem Verriegelungskopf (76, 78) die Verriegelungsöffnung (76) übergreift.

9. Versiegeltes Gehäuse (2) nach Anspruch 7 oder 8, **dadurch gekennzeichnet, dass** zwischen der Einbringöffnung (72) und der zugeordneten Verriegelungsöffnung (74) ein vorspringender Rastnocken (80) vorgesehen ist.

10. Versiegeltes Gehäuse (2) nach einem der Ansprüche 7 bis 9, **dadurch gekennzeichnet, dass** die Verriegelungsköpfe (76, 78) an dem Gehäuseunterteil (4) und dem Gehäusedeckel (6) vorgesehen sind und eine Außenfläche (3) des Gehäuses (2) überragen und dass die Einbring- und Verriegelungsöffnungen (72, 74) an dem Verriegelungsschieber (70) ausgespart sind.

11. Versiegeltes Gehäuse (2) nach einem der vorherigen Ansprüche, **dadurch gekennzeichnet, dass** das längliche Formschlusselement (60, 70) sich parallel zu der Außenfläche (3) des Gehäuses (2) erstreckt.

12. Versiegeltes Gehäuse (2) nach einem der vorherigen Ansprüche, **dadurch gekennzeichnet, dass** das längliche Formschlusselement (60, 70) an der Außenfläche (3) des Gehäuses (2) anliegt.

13. Versiegeltes Gehäuse (2) nach einem der vorherigen Ansprüche, **dadurch gekennzeichnet, dass** der Gehäusedeckel (6) aus einem gut wärmeleitenden Werkstoff gebildet ist und wenigstens in das Gehäuseunterteil (4) hineinragende Heizrippe (18) ausbildet, die mit einer U-förmigen Ausnehmung (20) versehen ist, die sich zu einer dem Gehäuseunterteil (4) gegenüberliegenden Anschlusskammer (30) öffnet und wenigstens ein elektrisches Heizelement (22) in sich aufnimmt, und dass das Gehäuseunterteil (4) aus Kunststoff gebildet ist.

14. Versiegeltes Gehäuse (2) nach Anspruch 13 **dadurch gekennzeichnet, dass** der Gehäusedeckel (6) einen die Anschlusskammer (30) umfänglich umgebenden Rand (42) ausbildet, auf dem ein Anschlusskammer-Deckel (44) aufliegt.

15. Verfahren zur Herstellung eines versiegelten Gehäuses (2) einer in ein Kraftfahrzeug einzubauenden Vorrichtung, insbesondere einer elektrischen Heizvorrichtung, mit einem Gehäuseunterteil (4) und einem Gehäusedeckel (6), die unter Zwischenlage eines Dichtelementes (24) aneinander anliegen,
bei dem zunächst das Gehäuseunterteil (4) und der Gehäusedeckel (6) als separate Bauteile hergestellt werden,
unter Zwischenlage und unter Kompression des Dichtelementes (24) gegeneinander angelegt werden, wobei zur Kompression des Dichtelementes (24) eine äußere Kraft auf das Gehäuseunterteil (4) bzw. den Gehäusedeckel (6) aufgebracht wird,
**dadurch gekennzeichnet,**
**dass** in einer Richtung im wesentlichen parallel zu einer Haupterstreckungsrichtung des Dichtelementes (24) ein längliches Formschlusselement (60, 70) zwischen einander gegenüberliegende Anlageflächen (50) von Gehäuseunterteil (4) und Gehäusedeckel (6) eingebracht wird und das Gehäuseunterteil (4) bzw. der Gehäusedeckel (6) von der äußeren Kraft entlastet wird, wodurch sich die Anlageflächen (50) unter einer Vorspannkraft der Dichtelementes (24) gegen das längliche Formschlusselement (60, 70) anlegen.

## Claims

1. A sealed housing (2) of a device to be installed in a motor vehicle, in particular an electric heating device, comprising a housing lower part (4) and a housing cover (6) abutting on the housing lower part (4) via an intermediate sealing element (24),
**characterized by** an elongate positive locking element (60, 70), which interconnects the housing lower part (4) and the housing cover (6) in a form fit manner and which is provided between opposed contact surfaces (50) of the housing lower part (4) and a housing cover (6) and abuts on the contact surfaces (50) under a pretensioning force caused by compression of the sealing element (24).

2. The sealed housing (2) according to claim 1, **characterized in that** the elongate positive locking element (60, 70) is retained in a form fit manner by retaining surfaces (58) extending transversely to the elongate positive locking element (60, 70) and projecting from the contact surfaces (50) of the housing lower part (4) and the housing cover (6), respectively.

3. The sealed housing (2) according to claim 1 or 2, **characterized in that** a projection is provided before and/or behind the elongate positive locking element (60, 70) in axial alignment therewith, the elongate positive locking element (60, 70) being held in its longitudinal direction by said projection in a form fit manner.

4. The sealed housing (2) according to any of the proceeding claims, **characterized in that** the housing lower part (4) and the housing cover (6) are provided with interengaging fastening sections (46, 52), which are provided alternately and in succession in the direction of extension of the elongate positive locking element (60) and which define the contact surfaces (50).

5. The sealed housing (2) according to claim 4, **characterized in that** the fastening sections (46, 52) comprise fastening heads (48, 54) projecting from an outer surface (3) of the housing (2) and defining the contact surfaces (50).

6. The sealed housing (2) according to claim 5, **characterized in that** the fastening heads (48, 54) are hook-shaped, wherein the fastening head (48) provided on the housing lower part (4) comprises a locking pin (56), which projects beyond the contact surface (50) and protrudes in the direction of the housing lower part (4), and/or the fastening head (54) provided on the housing cover (6) comprises a locking pin (56), which projects beyond the contact surface (50) and protrudes in the direction of the housing cover (6).

7. A sealed housing (2) of a device to be installed in a motor vehicle, in particular an electric heating device, comprising a housing lower part (4) and a housing cover (6) abutting on the housing lower part (4) via an intermediate sealing element (24),
**characterized by** a plurality of locking heads (76, 78) and a locking slide (70) configured as an elongate positive locking element, wherein the locking heads (76, 78) are adapted to be passed through insertion openings (72) formed on the locking slide (70) and/or the housing lower part (4) and the housing cover (6), respectively, and to be inserted into locking openings (74) adjoining the insertion openings (72) by displacing the locking slide (70), so that due to the combined effect of the locking heads (76, 78) and the insertion openings (72) a form fit connection is accomplished between the housing lower part (4) and the housing cover (6), the locking slide (70) abutting on the locking heads (76, 78) under a pretensioning force caused by compression of the sealing element (24).

8. The sealed housing (2) according to claim 7, **characterized in that** the locking heads (76, 78) comprise a locking projection (82) protruding beyond the contact surface (50), and that the locking opening (74) is adapted to the associated locking head (76, 78) such that, when the locking head (76, 78) is accommodated in the locking opening (74), the locking projection (82) overlaps the locking opening (74).

9. The sealed housing (2) according to claim 7 or 8, **characterized in that** a projecting locking cam (80) is provided between the insertion opening (72) and the associated locking opening (74).

10. The sealed housing (2) according to any of the claims 7 to 9, **characterized in that** the locking heads (76, 78) are provided on the housing lower part (4) and the housing cover (6) and project beyond an outer surface (3) of the housing (2), and that the insertion and locking openings (72, 74) are formed on the locking slide (70).

11. The sealed housing (2) according to any of the proceeding claims, **characterized in that** the elongate positive locking element (60, 70) extends parallel to the outer surface (3) of the housing (2).

12. The sealed housing (2) according to any of the proceeding claims, **characterized in that** the elongate positive locking element (60, 70) abuts on the outer surface (3) of the housing (2).

13. The sealed housing (2) according to any of the proceeding claims, **characterized in that** the housing cover (6) is formed of a highly heat-conductive material and forms a radiator (18) projecting at least into the housing lower part (4) and provided with a U-shaped opening (20), which opens towards a connection chamber (30) arranged in opposed relationship with the housing lower part (4), said U-shaped opening (20) accommodating at least one electric heating element (22), and that the housing lower part (4) is made of plastic.

14. The sealed housing (2) according to claim 13, **characterized in that** the housing cover (6) forms an edge (42), which extends circumferentially around the connection chamber (30) and on which a connection chamber cover (44) rests.

15. A method of producing a sealed housing (2) of a device to be installed in a motor vehicle, in particular an electric heating device, comprising a housing lower part (4) and a housing cover (6) abutting on one another via an intermediate sealing element (24),
wherein the housing lower part (4) and the housing cover (6) are first produced as separate components,
are positioned such that they abut against one another under compression of the sealing element (24) disposed therebetween, an external force being applied to the housing lower part (4) and the housing cover (6), respectively, so as to compress the sealing element (24),
**characterized in that,**
in a direction essentially parallel to a main direction of extension of the sealing element (24), an elongate positive locking element (60, 70) is introduced between opposed contact surfaces (50) of the housing lower part (4) and the housing cover (6), and the housing lower part (4) and the housing cover (6), respectively, are relieved from the external force, whereby the contact surfaces (50) move into contact with the elongate positive locking element (60, 70) under a pretensioning force of the sealing element (24).

## Revendications

1. Boitier scellé (2) d'un dispositif à implanter dans un véhicule automobile, notamment d'un dispositif de chauffage électrique, comprenant une partie de boitier inférieure (4) et un couvercle de boitier (6), qui s'appuie sur la partie inférieure de boitier (4) avec interposition d'un élément d'étanchéité (24), **caractérisé par** un élément d'assemblage par complémentarité de formes (60, 70) allongé, qui relie la partie inférieure de boitier (4) et le couvercle de boitier (6) par complémentarité de formes, et est prévu entre des surfaces d'appui (50) mutuellement opposées de la partie inférieure de boitier (4) et d'un couvercle de boitier (6), et qui s'appuie sur les surfaces d'appui (50) sous une force de précontrainte produite par la compression de l'élément d'étanchéité (24).

2. Boitier scellé (2) selon la revendication 1, **caractérisé en ce que** l'élément d'assemblage par complémentarité de formes (60, 70) allongé est maintenu par complémentarité de formes grâce à des surfaces de maintien (58), qui s'étendent transversalement à l'élément d'assemblage par complémentarité de formes (60, 70) allongé, et font saillie des surfaces d'appui (50) de la partie inférieure de boitier (4) et respectivement du couvercle de boitier (6).

3. Boitier scellé (2) selon la revendication 1 ou la revendication 2, **caractérisé en ce qu'**en prolongement axial de l'élément d'assemblage par complémentarité de formes (60, 70) allongé, il est prévu devant et/ou derrière l'élément d'assemblage par complémentarité de forme (60, 70) allongé, une protubérance par laquelle l'élément d'assemblage par complémentarité de forme (60, 70) allongé est maintenu par complémentarité de formes dans sa direction longitudinale.

4. Boitier scellé (2) selon l'une des revendications précédentes, **caractérisé en ce que** la partie inférieure de boitier (4) et le couvercle de boitier (6) présentent des tronçons de fixation (46, 52) engrenant mutuellement, qui, dans la direction d'étendue de l'élément d'assemblage par complémentarité de formes (60) allongé, sont prévus de manière alternée et successive et forment les surfaces d'appui (50).

5. Boitier scellé (2) selon la revendication 4, **caractérisé en ce que** les tronçons de fixation (46, 52) présentent des têtes de fixation (48, 54) faisant saillie d'une surface extérieure (3) du boitier (2) et formant les surfaces d'appui (50).

6. Boitier scellé (2) selon la revendication 5, **caractérisé en ce que** les têtes de fixation (48, 54) sont réalisées en forme de crochet, la tête de fixation (48) prévue sur la partie inférieure de boitier (4) présente un embout de verrouillage (56), qui dépasse de la surface d'appui (50) et fait saillie en direction de la partie inférieure de boitier (4), et/ou la tête de fixation (54) prévue sur le couvercle de boitier (6) présente un embout de verrouillage (56), qui dépasse de la surface d'appui (50) et fait saillie en direction du couvercle de boitier (6).

7. Boitier scellé (2) d'un dispositif à implanter dans un véhicule automobile, notamment d'un dispositif de chauffage électrique, comprenant une partie de boitier inférieure (4) et un couvercle de boitier (6), qui s'appuie sur la partie inférieure de boitier (4) avec interposition d'un élément d'étanchéité (24), **caractérisé par** plusieurs têtes de verrouillage (76, 78) et un coulisseau de verrouillage (70) réalisé en tant qu'élément d'assemblage par complémentarité de formes allongé, l'ensemble étant tel que les têtes de verrouillage (76, 78) puissent passer à travers des ouvertures d'insertion (72) évidées dans le coulisseau de verrouillage (70) et/ou dans la partie inférieure de boitier (4) respectivement le couvercle de boitier (6), et, par coulissement du coulisseau de verrouillage (70), puissent être introduites dans des ouvertures de verrouillage (74) se raccordant aux ouvertures d'insertion (72), de sorte que par l'interaction des têtes de verrouillage (76, 78) avec les ouvertures d'insertion (72), on obtient une liaison par complémentarité de formes de la partie inférieure de boitier (4) et du couvercle de boitier (6), le coulisseau de verrouillage (70) s'appuyant contre les têtes de verrouillage (76, 78) sous une force de précontrainte produite par la compression de l'élément d'étanchéité (24).

8. Boitier scellé (2) selon la revendication 7, **caractérisé en ce que** les têtes de verrouillage (76, 78) présentent une protubérance de verrouillage (82) dépassant de la surface d'appui (50), et **en ce que** l'ouverture de verrouillage (74) est adaptée à la tête de verrouillage (76, 78) associée, de façon à ce que la protubérance de verrouillage (82) surmonte l'ouverture de verrouillage (74) lorsque la tête de verrouillage (76, 78) est reçue dans l'ouverture de verrouillage (74).

9. Boitier scellé (2) selon la revendication 7 ou la revendication 8, **caractérisé en ce qu'**entre l'ouverture d'insertion (72) et l'ouverture de verrouillage (74) associée, est prévu un cran d'encliquetage (80) en saillie.

10. Boitier scellé (2) selon l'une des revendications 7 à 9, **caractérisé en ce que** les têtes de verrouillage (76, 78) sont prévues sur la partie inférieure de boitier (4) et le couvercle de boitier (6), et dépassent ou font saillie d'une surface extérieure (3) du boitier (2), et **en ce que** les ouvertures d'insertion et de verrouillage (72, 74) sont évidées dans le coulisseau de verrouillage (70).

11. Boitier scellé (2) selon l'une des revendications précédentes, **caractérisé en ce que** l'élément d'assemblage par complémentarité de forme (60, 70) allongé, s'étend parallèlement à la surface extérieure (3) du boitier (2).

12. Boitier scellé (2) selon l'une des revendications précédentes, **caractérisé en ce que** l'élément d'assemblage par complémentarité de forme (60, 70) allongé, s'appuie sur la surface extérieure (3) du boitier (2).

13. Boitier scellé (2) selon l'une des revendications précédentes, **caractérisé en ce que** le couvercle de boitier (6) est réalisé en un matériau bon conducteur de la chaleur, et forme au moins une nervure de chauffage (18) faisant saillie à l'intérieur de la partie inférieure de boitier (4) et pourvue d'un évidement (20) en forme de U, qui s'ouvre en direction d'un compartiment de raccordement (30) en regard de la partie inférieure de boitier (4) et accueille au moins un élément chauffant électrique (22), et **en ce que** la partie inférieure de boitier (4) est réalisée en matière plastique.

14. Boitier scellé (2) selon la revendication 13, **caractérisé en ce que** le couvercle de boitier (6) forme une bordure (42) entourant de manière périphérique le compartiment de raccordement (30), et sur lequel vient s'appliquer un couvercle de compartiment de raccordement (44).

15. Procédé de fabrication d'un boitier scellé (2) d'un dispositif à implanter dans un véhicule automobile, notamment d'un dispositif de chauffage électrique, comprenant une partie de boitier inférieure (4) et un couvercle de boitier (6), qui s'appuient l'un contre l'autre avec interposition d'un élément d'étanchéité (24), procédé
d'après lequel on fabrique tout d'abord la partie inférieure de boitier (4) et le couvercle de boitier (6) sous forme de pièces séparées,
et d'après lequel on les applique l'un contre l'autre avec interposition et compression de l'élément d'étanchéité (24), la compression de l'élément d'étanchéité (24) étant obtenue en appliquant une force extérieure sur la partie inférieure de boitier (4) respectivement sur le couvercle de boitier (6),
**caractérisé**
**en ce que** dans une direction sensiblement parallèle à une direction d'étendue principale de l'élément d'étanchéité (24), on met en place un élément d'assemblage par complémentarité de formes (60, 70) allongé, entre des surfaces d'appui (50) mutuellement opposées de la partie inférieure de boitier (4) et du couvercle de boitier (6), et on décharge la partie inférieure de boitier (4) respectivement le couvercle de boitier (6) de ladite force extérieure, les surfaces d'appui (50) s'appuyant ainsi, sous une précontrainte de l'élément d'étanchéité (24), contre l'élément d'assemblage par complémentarité de formes (60, 70) allongé.
